# EUROPEAN PATENT SPECIFICATION

(11) **EP 0 793 408 B1**
(45) Date of publication and mention of the grant of the patent: **15.09.2004**
(21) Application number: 97101785.0
(22) Date of filing: 05.02.1997
(51) Int. Cl.: H05K 13/00

(54) **Pallet, transport apparatus and method utilizing such pallet**
Palette, Transporteinrichtung und Methode dafür
Palette, appareil de transport et méthode d'utilisation

(30) Priority: 27.02.1996 JP 3945396; 19.04.1996 JP 9821496
(43) Date of publication of application: 03.09.1997
(73) Proprietor: MATSUSHITA ELECTRIC INDUSTRIAL CO., LTD., Kadoma-shi, Osaka 571-8501 (JP)
(72) Inventor: Yotsumoto, Mikio, Ibaraki-shi, Osaka-fu (JP); Takamori, Kazumi, Takatsuki-shi, Osaka-fu (JP); Fujita, Eiji, Ibaraki-shi, Osaka-fu (JP); Matsuda, Yutaka, Toyonaka-shi, Osaka-fu (JP); Sugiura, Hiromitsu, Nagaokakyo-shi, Kyoto-fu (JP); Shimizu, Kaoru, Osaka-shi, Osaka-fu (JP)
(74) Representative: Eisenführ, Speiser & Partner

(56) References cited:
- EP-A- 0 487 315
- FR-A- 2 524 435
- GB-A- 1 414 638
- US-A- 4 910 864
- US-A- 5 361 893

## Description

### BACKGROUND OF THE INVENTION

### (Field of the Invention)

The present invention generally relates to a pallet for the support of at least one article to be transported, a transport apparatus utilizing the pallets and a method of transporting the pallets together with articles loaded thereon.

More specifically, the present invention relates to transportation of the article, such as electronic component parts and/or printed circuit boards or component-mounted chassis for television receiver sets or the like, of a kind fragile and/or susceptible to damage when otherwise subjected to shock or vibration particularly in a factory assembly line.

### (Description of the Prior Art)

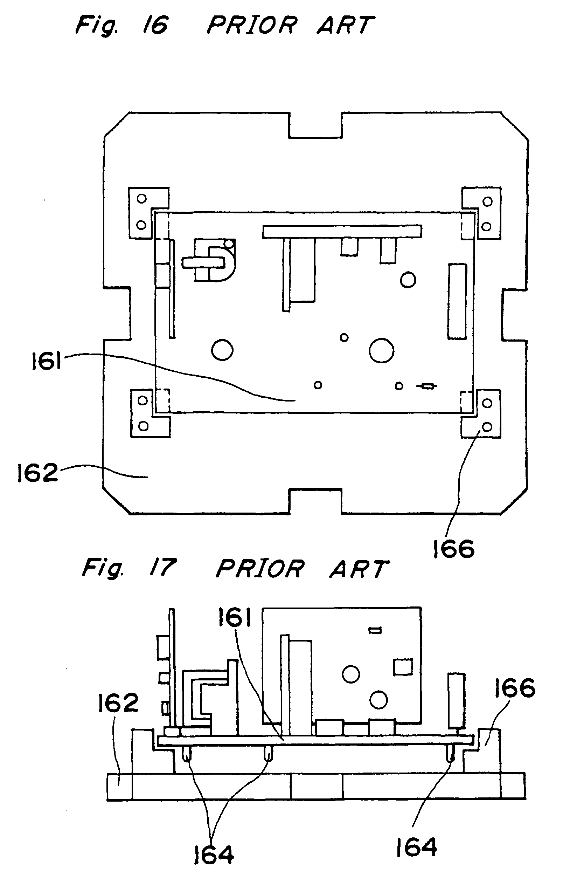

A known pallet for the support of an article for the support of an article to be transported is schematically shown in plan and side views in Figs. 16 and 17, respectively, and generally identified by 162. The article shown as mounted on the pallet 162 is a printed circuit board or chassis 161 having various electric component parts mounted thereon. Specifically, the printed circuit board 161 has top and bottom surfaces opposite to each other with the electric component parts mounted mainly on the top surface thereof. Some minute electric component parts may be mounted on the bottom surface of the printed circuit board 161. The printed circuit board 161 also has a plurality of spacer legs 164 protruding outwardly from the bottom surface thereof for protecting circuit elements secured to the bottom surface of the printed circuit board which would be likely to be damaged when they are held in direct contact with a support surface such as, for example, a moving conveyor belt.

The illustrated pallet 162 is of a generally rectangular flat configuration and has a loading surface provided with a plurality of, for example, four, L-shaped positioning members 166 fixedly mounted thereon. Considering that the printed circuit board 162 is generally rectangular in shape, those positioning members 166 are disposed in a pattern necessary to lift the printed circuit board 161 above the loading surface of the pallet 162 a distance sufficient to render the spacer legs 164 clear from the loading surface and also to trap the corresponding corners of the printed circuit board 161 to thereby restrain the latter immovably.

The pallet 162 is generally in the form of a plate having a sufficient rigidity and made of, for example, wood including bonded plywood, metal such as steel or aluminum, or plastics such as ABS, PS, PP, polyvinyl chloride, polyethylene, epoxy or acrylic resin.

In another known version, the loading surface of the pallet 162 may have a thin protective layer formed thereon for protecting the article to be transported from being damaged. This protective layer is either a protective sheet of a thickness of about 0.5 to 2 mm made of rubber or any other resinous material and bonded to the loading surface of the pallet 162 or a coating of a resinous paint material painted on the loading surface to a thickness of a few tens to a few hundreds micron.

The protective sheet bonded to the loading surface of the prior art pallet is generally hard (i.e., having a high hardness) and has a smooth outer surface with low coefficient of friction. Accordingly, when the article to be transported is mounted on the pallet, the depth of depression to which the protective sheet is elastically dented or sunk by the weight of the article placed thereon is extremely small. This means that the article mounted on the pallet is insufficiently stuck in the protective sheet to such an extent that the magnitude of a pushing force necessary to displace the articles on the protective sheet may correspond to the weight of the article multiplied by the coefficient of friction of the protective sheet. Thus, in selecting the protective sheet to be bonded to the loading surface of the prior art pallet, the hardness of the protective sheet has never been taken into consideration.

On the other hand, attempts have been made to fully automate the assembly line for the production of, for example, television receiver sets with no substantial intervention of manual labors and, in the course of this automation, automatic loading and unloading of printed circuit boards or chassis onto and from pallets has come to be essential. In order to realize the full automation of the assembly line, displacement in position of the article relative to the corresponding pallet during transportation will not be permitted and, therefore, the prior art pallet has long required the use of the positioning members such as identified by 166 in Figs. 16 and 17.

The use of the positioning members on the pallet has, however, been found having the following problems.

In the first place, once the positioning members are fixed relative to the pallet in light of the article of a particular size and/or shape, such pallet can no longer be used for the support of the article of a different size and/or shape. Accordingly, in the prior art pallet, the positioning members are adjustably, removably or interchangeably disposed on the pallet so that the positioning members can be repositioned so as to accommodate the different size and/or shape of the article. Not only is this indeed complicated and time-consuming, but a loss of working time is also involved, accompanied by reduction in productivity and also in efficiency of utilization of factory facilities.

Where no positioning member is employed during conveyance of the pallet with the article mounted thereon, cyclic start and halt of the conveyor will impose shock on the articles placed on the pallet and, by the effect of this shock, the article may considerably displace from the position on the pallet at which it has initially been placed.

### SUMMARY OF THE INVENTION

Accordingly, the present invention has for its essential object to provide an improved pallet of a type on which the article can be consistently positioned with no need to use any positioning member.

Another important object of the present invention is to provide an improved pallet of the type referred to above, which is capable of accommodating a different size and/or shape of the article to be transported.

It is a related object of the present invention to provide a transport apparatus capable of conveying successively the pallets of the type referred to above.

It is also another related object of the present invention to provide a method of transporting an article by the use of the pallet of the type referred to above.

In order to achieve the above and further objects, according to the present invention there is provided a pallet for the support of an electronic article thereon, said electronic article having a plurality of projections protruding outwardly therefrom, which pallet comprises first and second surfaces opposite to each other, said first surface adapted to support the electronic article thereon, characterized in that said first surface is capable of being detented by the weight of the article at respective locations aligned with the projections of the electronic article when the latter is placed thereon, to thereby prevent the electronic article from being displaced in position relative to the pallet.

In one preferred embodiment of the present invention, the pallet comprises a base having a loading surface adapted to support the article thereon; and a flexible covering fitted to the loading surface. The flexible covering is capable of being dented a predetermined depth, for example, about 0.5 to 50 mm, by the weight of the article when the latter is placed thereon, to thereby prevent the article from being displaced in position relative to the pallet.

The flexible covering may be a soft sheet, a sponge sheet, a honeycomb structure sandwiched between skin layers, a generally flattened hollow member or a textile sheet.

In the case of the soft sheet, it may be made of a material selected from the group consisting of rubber such as, for example, silicone rubber, fluorine rubber, butyl rubber, urethane rubber or natural rubber and plastics such as, for example, silicone, polyvinyl chloride, nylon or styrene.

In the case of the sponge sheet, it may comprise a layer of sponge material sandwiched between skin layers and made of foamed silicone rubber or formed urethane rubber.

In the case of the hollow member, it may have a plurality of hollows defined therein and partitioned by a partition wall. Those hollows may be either closed or communicated with each other.

In the case of the textile sheet, it may be made of a textile material selected from the group consisting of a web of woven fabric, a web of non-woven fabric, a web of felt, a web of blanket, a sheet knitted with woolen yarn, and a quilted fabric having a cushioning material sandwiched between and sewn together with webs of fabric.

According to another aspect of the present invention, there is provided a transport apparatus which makes use of the pallet of the structure discussed above. This transport apparatus may comprise, in addition to the pallet, a conveyor for transporting the article together with the pallet carrying such article thereon, which conveyor may be a belt conveyor, a chain conveyor, a roller conveyor or a combination thereof.

According to a further aspect of the present invention, there is provided a method of transporting an article by a transport means and the pallet of the structure discussed above. According to this method, when the article is placed on the pallet, the first surface of the pallet or the covering on the base of the pallet is detented by the weight of the article to thereby prevent the article from being displaced in position relative to the pallet during transportation of the article.

In any event, the present invention dispenses with the need to use positioning members hitherto required to avoid any possible displacement of the article relative to the pallet. This is because the detent or depression left on the pallet by the effect of the weight of the article mounted thereon steadily holds the article without allowing the latter to displace relative to the pallet.

The absence of any positioning member on the pallet makes it possible for the single pallet to accommodate a different size and/or shape of the article.

Where a plurality of articles of identical or different size and/or shape are to be transported, the corresponding pallets may have either an equal size and/or shape or different sizes and/or shapes.

### BRIEF DESCRIPTION OF THE DRAWINGS

This and other objects and features of the present invention will become clear from the following description taken in conjunction with preferred embodiments thereof with reference to the accompanying drawings, in which like parts are designated by like reference numerals and in which:
Fig. 1 is a schematic top plan view of a pallet according to a first preferred embodiment of the present invention with a printed circuit board mounted thereon;
Fig. 2 is a schematic side view of the pallet shown in Fig. 1;
Fig. 3 is a fragmentary sectional view, on an enlarged scale, of a portion of the pallet with the printed circuit board mounted thereon;
Fig. 4 is a fragmentary sectional view of a modified form of the pallet;
Fig. 5 is a view similar to Fig. 4, showing another modified form of the pallet;
Fig. 6 is a schematic top plan view of a covering fitted to the pallet according to a second preferred embodiment of the present invention;
Fig. 7 is a schematic end view of the covering shown in Fig. 6;
Fig. 8 is a view similar to Fig. 6, showing a modified form of the covering;
Fig. 9 is a cross-sectional view taken along the line IX-IX in Fig. 8;
Fig. 10 is a schematic perspective view of a further modified form of the covering;
Fig. 11 is a cross-sectional view taken along the line XI-XI in Fig. 10;
Fig. 12 is a top plan view of the covering fitted to the pallet according to a third preferred embodiment of the present invention;
Fig. 13 is an end view of the covering shown in Fig. 12;
Fig. 14 is a fragmentary sectional view of the covering fitted to the pallet according to the first embodiment of the present invention;
Fig. 15 is a schematic perspective view of a transport apparatus embodying the present invention;
Fig. 16 is a schematic top plan view of the prior art pallet with the printed circuit board mounted thereon; and
Fig. 17 is a side view of the prior art pallet shown in Fig. 16.

### DETAILED DESCRIPTION OF THE EMBODIMENTS

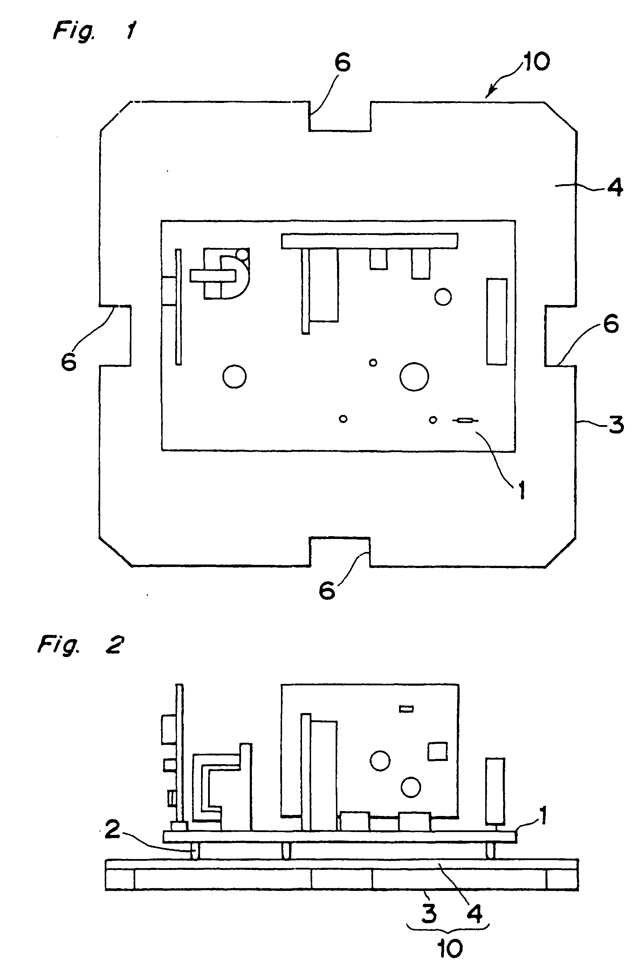

### Embodiment 1 (Figs. 1 to 3)

Referring to Figs. 1 to 3, there is shown a pallet 10 according to a first preferred embodiment of the present invention. The pallet 10 shown therein comprises a generally rectangular base plate 3 having top and bottom surfaces opposite to each other and a covering bonded at 5 to the top surface of the base plate 3 by the use of any suitable bonding agent. The covering referred to above is, in the illustrated embodiment, employed in the form of a soft sheet 4 made of rubber material or plastic materia and having a hardness of not greater than 50 degrees and preferably within the range of 35 to 50 degrees.

Where the rubber material is used as material for the soft sheet 4, any one of silicone rubber, fluorine rubber, butyl rubber, polyurethane rubber or natural rubber may be employed. On the other hand, where the plastic material is used as material for the soft sheet 4, any plastic material of silicone, polyvinyl chloride, nylon or styrene system may be employed.

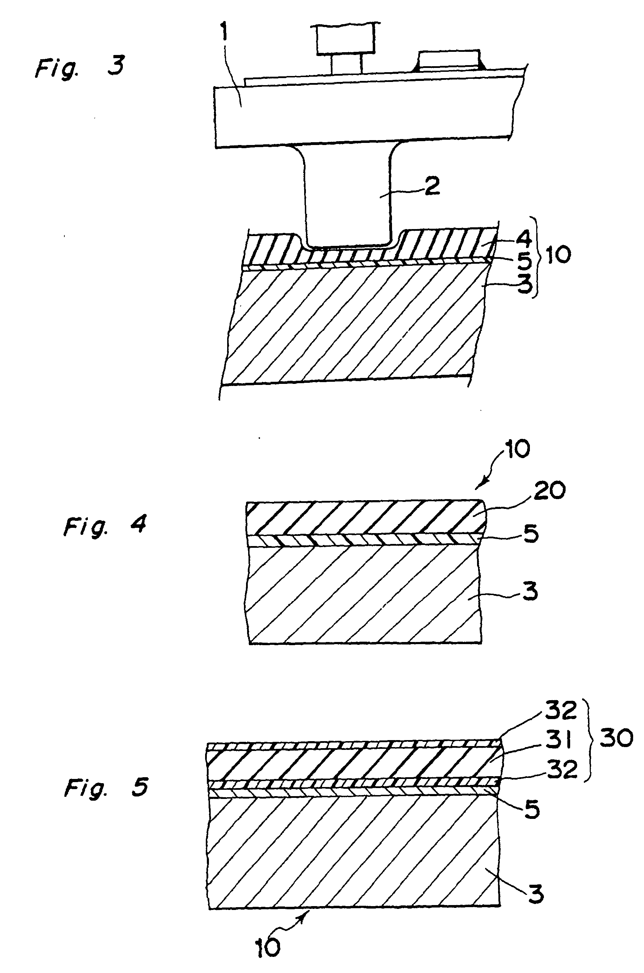

An article to be mounted on the pallet 10 according to the present invention, for example, a printed circuit board 1, has top and bottom surfaces opposite to each other with electric component parts mounted mainly on the top surface thereof. Some minute electric component parts may be mounted on the bottom surface of the printed circuit board 1. The printed circuit board 1 also has a plurality of positioning legs 2 protruding outwardly from the bottom surface thereof. When the printed circuit board 1 is mounted on the pallet 10, the soft sheet 4 on the base plate 3 is detented as best shown in Fig. 3 at locations aligned respectively with the positioning legs 2 by the effect of the weight of the printed circuit board 1, to thereby keep the mounted printed circuit board 1 immovable on the pallet 10.

For this purpose, the soft sheet 4 bonded to the top surface of the base plate 3 by means of the bond deposit 5 is of a kind in which respective areas of an outer surface thereof which are aligned with the positioning legs 2 can, when the printed circuit board 1 is mounted on the pallet 10, be detented or sunk a distance of 0.5 to 5 mm inwardly by the effect of the weight of the printed circuit board 1 as if the soft sheet 4 were formed with respective pits for receiving the positioning legs 2 to keep the printed circuit board 1 immovable sidewise relative to the pallet 10. Accordingly, even though the conveyor is cyclically started and halted, the printed circuit board 1 mounted on the pallet 10 can advantageously be steadily supported thereon without being displaced from the position on the pallet 10 at which it has initially been placed.

It should be noted that the soft sheet 4 is preferably so elastic that once the printed circuit board 1 is removed from the pallet 10, those surface areas of the soft sheet 4 which had been detented or sunk in contact with the positioning legs 2 by the effect of the weight of the printed circuit board 1 can restore to the original surface level, although it is not always essential. Repeated use of the pallet 10 over a few hundreds of thousands to a few millions cycles may result in setting of detents or depressions in the outer surface of the soft sheet 4. The pallet 10 in which such detents are set in the soft sheet 4 can be satisfactorily used in practice since the detents once set in the soft sheet 4 serves as positioning recesses cooperable with the positioning legs 2 rigid with the printed circuit board 1.

The particular hardness of the soft sheet 4 and its thickness and size may be suitably chosen in consideration of the size and/or weight of the article to be placed thereon and/or the speed at which the pallet 10 carrying the article is transported.

Thus, according to the present invention, the pallet 10 makes no use of any positioning member such as required in the prior art pallet and can be used in connection with different sizes and/or shapes of various articles to be transported.

It is to be noted that if desired, the pallet 10 may have one or more cutouts 6 one defined in each side edge thereof as shown in Fig. 1.

Alternatively, the covering bonded to the top surface of the base plate 3 by means of the bond deposit 5 may be in the form of a sponge sheet 20 as shown in Fig. 4. As is the case with the soft sheet 4, the sponge sheet 20 is of a kind in which respective areas of an outer surface thereof which are aligned with the positioning legs 2 can, when the printed circuit board 1 is mounted on the pallet 10, be detented or sunk a distance of 0.5 to 5 mm inwardly by the effect of the weight of the printed circuit board 1 as if the sponge sheet 20 were formed with respective pits for receiving the positioning legs 2 to keep the printed circuit board 1 immovable sidewise relative to the pallet 10.

The particular hardness of the sponge sheet 20 and its thickness and size may be suitably chosen in consideration of the size and/or weight of the article to be placed thereon and/or the speed at which the pallet 10 carrying the article is transported.

The sponge sheet 20 may be made of any suitable sponge material such as, for example, silicone rubber or polyurethane rubber. However, in a variant shown in Fig. 5, the sponge sheet identified by 30 comprises a layer of foamed plastics 31 such as, for example, expanded silicone rubber or expanded polyurethane rubber sandwiched between skin plies 32. Even where the sponge sheet 30 is employed as the covering bonded to the base plate 3, the sponge sheet 30 can be similarly detented or sunk at local surface areas aligned with the positioning legs 2 by the effect of the weight of the printed circuit board 1 to thereby keep the printed circuit board 1 immovable sidewise relative to the pallet 10.

The expanded silicone rubber used as material for the foamed plastic layer 31 may be of a composition comprising a thermosetting malleable silicone rubber compound containing a polyorganosiloxane-based polymer, a reinforcing silica filler material and a hardening agent as principal components thereof, mixed with thermoexpandable microcapsules in a quantity of 0.1 to 20% by weight relative to 10 parts by weight of polyorganosiloxane-based polymer.

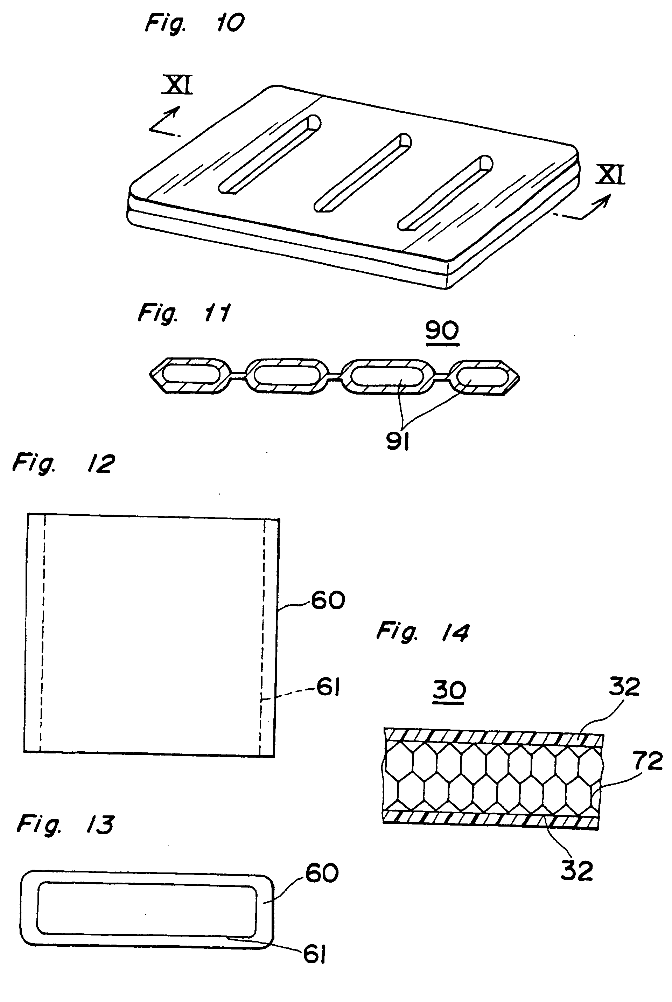

As shown in Fig. 14, in place of the foamed plastic layer 31 shown in Fig. 5, a honeycomb layer 72 may be employed as shown in Fig. 14. The use of the honeycomb layer 72 is particularly advantageous in that the resultant pallet can have a reduced weight and also has a rigidity against the load imposed on the pallet. In addition, where the honeycomb layer 72 is employed in place of the foamed plastic layer 31, one of the skin plies 32 which is positioned remote from the base plate can be similarly detented or sunk at local areas aligned with the positioning legs 2 by the effect of the weight of the printed circuit board 1 to thereby keep the printed circuit board 1 immovable sidewise relative to the pallet.

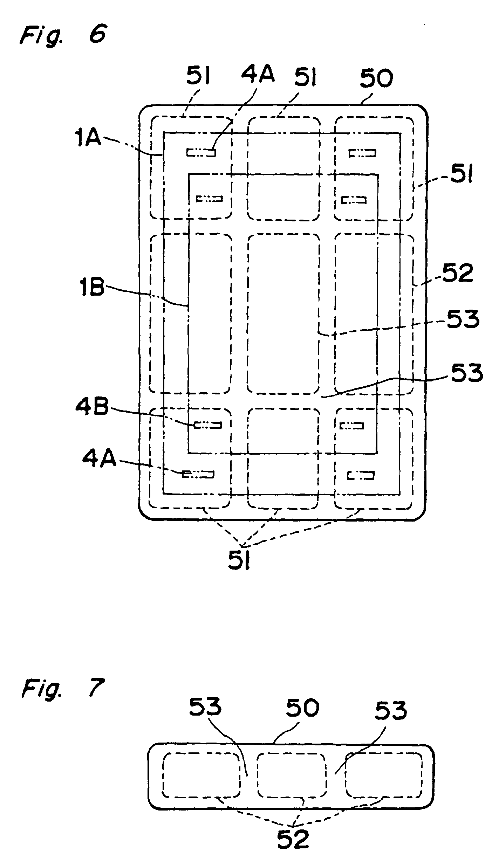

### Second Embodiment (Figs. 6 and 7)

The pallet according to a second preferred embodiment of the present invention shown in Figs. 6 and 7 differs from that according to the foregoing embodiment as to the details of the covering bonded to the base plate 3 shown in Figs. 1 to 5.

The covering shown in Figs. 6 and 7 comprises a generally flattened hollow member 50 having a plurality of independent hollows 51 and 52 defined therein by a grid-patterned partition wall 53. As best shown in Fig. 6, three of the independent hollows 51 adjacent each end of the hollow member 50 are smaller in size than the three independent hollows 52 defined in the hollow member 50 at a location substantially intermediate between the opposite ends thereof, although all of the hollows 51 and 52 may be of a uniform volume. The pallet having the hollow member 50 bonded thereto can be used to support thereon one at a time articles, for example, printed circuit boards, of different shapes shown by the phantom lines 1A and 1B, respectively. It is to be noted that in Fig. 6, reference numeral 4A represents legs rigid with the relatively large article shown by the phantom line 1A whereas reference numeral 4B represents legs rigid with the relatively small article shown by the phantom line 1B.

According to the embodiment shown in Figs. 6 and 7, when the article is placed on the hollow member 50 fast with the pallet, an outer surface of the hollow member 50 remote from the base plate 3 is detented or sunk by the weight of the article at respective locations aligned with the legs 4A or 4B as if the outer surface of the hollow member 50 were formed with respective pits for receiving the legs 4A or 4B to keep the article immovable sidewise relative to the pallet. The thickness and size of the partition wall 53 and the shape and size of the hollows may be chosen in consideration with the shape and weight of the article to be transported as mounted on the pallet.

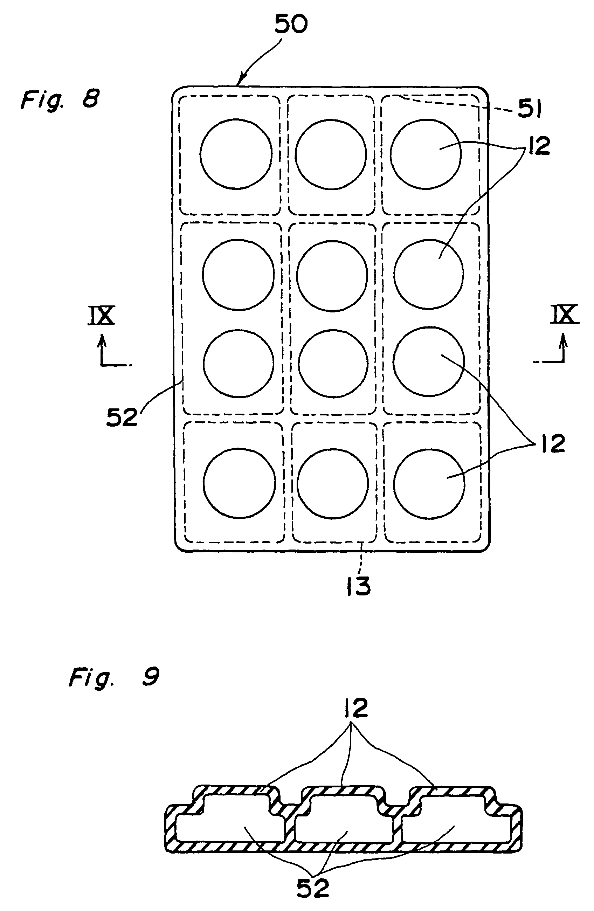

Alternatively as shown in Figs. 8 and 9, respective portions of the outer surface of the hollow member 50 which are aligned with the hollows 51 and 52 may be convexed at 12 so as to provide generally thin-walled round protrusions. Some or all of those thin-walled round protrusions 12 are utilized to support, and be therefore detented by, the legs 4A or 4B of the article 1 A or 1B when the latter is mounted on the pallet utilizing the hollow member 50 of the structure shown in Figs. 8 and 9, to thereby keep the mounted article immovable sidewise relative to the pallet.

The shape and size of the thin-walled protrusions 12, the pattern in which the thin-walled protrusions 12 are formed and/or the number of the thin-walled protrusions 12 to be employed may be determined in consideration with the weight and shape of the article to be transported as mounted on the pallet.

Again alternatively, the hollow member as identified by 90 in Figs. 10 and 11 may have a plurality of hollows 91 defined therein by a patterned partition wall and communicated with each other. Even with the modified hollow member 90, an outer surface of the modified hollow member 90 remote from the base plate of the pallet can be detented or sunk by the weight of the article at respective locations aligned with the legs as if the outer surface of the hollow member 90 were formed with respective pits for receiving the legs to keep the article immovable sidewise relative to the pallet. Not only can the partition wall make it possible for the modified hollow member 90 to support the article having a substantial weight, but communication of the hollows 91 with each other permits internal air to flow freely among the hollows 90 to keep the outer surface at a horizontal level.

### Third Embodiment (Figs. 12 and 13)

The pallet according to a third preferred embodiment of the present invention shown in Figs. 12 and 13 differs from that according to any one of the foregoing embodiments as to the details of the covering bonded to the base plate 3 shown in Figs. 1 to 5.

The covering shown in Figs. 12 and 13 comprises a generally tubular member 60 permanently set to represent a generally rectangular sectional shape as shown in Fig. 13, leaving an open-ended hollow 61 therein. This tubular member 60 may be manufactured from a rubber or resinous material by the use of an extrusion molding technique or an injection molding technique or may be manufactured by bonding segments together to represent a shape such as shown therein.

A surface area of the article which rests on the pallet of the present invention may not be always flat and may be convexed and/or concaved or may have a matrix pattern of round or rectangular protrusions. Accordingly, when such article is placed on the tubular member 60 bonded to the base plate 3 of the pallet, the outer surface of the tubular member 60 can be detented or sunk by the weight of the article at respective locations aligned with the protrusions as if the outer surface of the hollow member 90 were formed with respective pits for receiving those protrusions to keep the article immovable sidewise relative to the pallet.

### Fourth Embodiment

The covering bonded to the base plate 3 may be in the form of a web of textile material such as, for example, woven or non-woven fabric, felt or blanket, a sheet knitted with woolen yarn, or a quilted fabric having a cushioning material sandwiched between and sewn together with webs of fabric, all having a substantial thickness. Even where such covering is employed, the outer surface of the covering can be detented or sunk by the weight of the article at respective locations aligned with the protrusions as if the outer surface of the hollow member 90 were formed with respective pits for receiving those protrusions to keep the article immovable sidewise relative to the pallet.

Fibrous material forming the web of textile material, the sheet knitted with woolen yarn or the quilted fabric may be cotton fibers, hemp fibers, woolen fibers or synthetic fibers such as those made of, for example, acrylic resin, PET (polyethylene terephthalate), nylon, polyester, PS, PP or polyvinyl chloride. The use of the synthetic fibers is preferred in terms of shape durability and lifetime.

The manner in which the web of textile material is sewn may be chosen suitably provided that an irregular surface effective to permit the article to accomplish a soft landing on the pallet and to be steadily caught on the pallet can be formed.

In the case of the sheet knitted with woolen yarn, the woolen yarn may be knitted in any manner and may have any suitable thickness. Any structure and material may be suitably chosen in the practice of the present invention.

In the case where the quilted fabric having the cushioning material sandwiched between and sewn together with the webs of fabric, the cushioning material used in the quilted fabric may be a sponge material, a lamination of a plurality of webs of fabric or any other suitable elastic material.

In such case, such an advantage can be appreciated that not only can a light-weight feature be achieved, but the article to be transported can be softly landed on the pallet without being damaged.

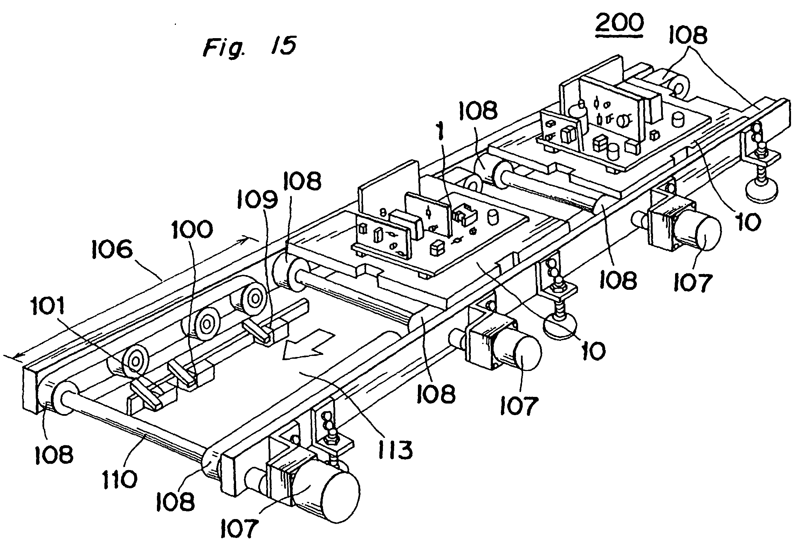

### Fifth Embodiment (Fig. 15)

A fifth preferred embodiment of the present invention shown in Fig. 15 is directed to a transport apparatus for transporting the article by the use of the pallet constructed according to any one of the foregoing embodiments of the present invention.

As shown in Fig. 15, the transport apparatus comprises a belt conveyor 200 in combination with at least one pallet 10, it being however to be noted that the two pallets 10 are shown in Fig. 15. The belt conveyor has a plurality of, for example, three, conveyor units 106 which may be of an identical construction.

Each conveyor unit 106 comprises a drive source 107 such as, for example, a drive motor, a drive shaft 110 drivingly coupled with the drive motor 107 through a suitable joint (not show) and having identical pulleys mounted on opposite ends thereof for rotation together therewith, two sets of spaced idle pulleys rotatably supported by common side frames, and generally endless belts 108 trained around the pulleys on the drive shaft 110 and the respective sets of the idle pulley. Each conveyor unit 106 is so designed and so structured that when the drive motor 107 is electrically activated, the belts 108 travel in the same direction as shown by the arrow.

Each conveyor unit 106 also comprises a limit switch 109 for changing the transport speed from low speed to high speed, another limit switch 100 for changing the transport speed from high speed to low speed and another limit switch 101 for deactivating the drive motor 107 and has a predetermined or required length.

The conveyor units 106 are connected in end-to-end fashion to complete the belt conveyor 200 of a length equal to the sum of the respective lengths of the conveyor units 106 and having respective processing stations 113, 114 and 115 each represented by the associated conveyor unit 106.

The operation of the transport apparatus will now be described. It is, however, to be noted that in Fig. 15, for the purpose of description the two pallets 10 each carrying the printed circuit board 1 are shown as mounted on the two conveyor units 106 representing the third and second processing stations 115 and 114.

Starting from the condition as shown in Fig. 15, and when the belts 108 of the conveyor unit 106 representing the second processing station 114 are driven, the pallet 10 in the second processing station 114 is transported at a low speed towards the conveyor unit 106 representing the first processing station 13. During the transport of the pallet 10 approaching the first processing station 113, the pallet 10 actuates the limit switch 109 so that the transport speed can be changed from low speed to high speed.

The limit switch 100 is subsequently actuated by the pallet 10 then transported by the belts 108 in the drive unit 106 representing the first processing station 113 to change the transport speed from high speed to low speed.

Further movement of the pallet 10 results in actuation of the limit switch 101 to halt the drive of the conveyor unit 106 representing the first processing station 113, thereby permitting the pallet 10 to held still at the first processing station 113.

Once the pallet 10 has been transported to the first processing station 113 in the manner described above, the second processing station 114 becomes empty and, therefore, the pallet 10 assuming the third processing station 115 is then transported towards the second processing station 114 in a manner similar to the transport of the pallet 10 from the second processing station 114 towards the first processing station 113. Thus, by the same token, the plural pallets 10 carrying the respective articles are successively transported from one conveyor unit to another and then completely through the entire length of the belt conveyor 200.

As described above, in the transport apparatus according to the present invention, the transport speed is lowered shortly before each drive unit 106 is deactivated and is increased after the respective drive unit 106 has been activated. This feature makes it possible to minimize to as small a value as possible the inertia force which will act on the article carried by the pallet 10 and hence to avoid any possible displacement of the article relative to the pallet 10 during the transportation along the belt conveyor 200.

It is to be noted that the number of the belts 108 may not be limited to two such as shown, and each conveyor unit 106 may have at least one endless belt, or three or more endless belts. In addition, each conveyor unit may not always be limited to the type utilizing the endless belts such as shown, but may be of a type utilizing endless chains or juxtaposed rollers or a combination thereof. Furthermore, the pallets 10 successively transported by the transport apparatus according to the present invention may not be always limited to those having an equal size and/or shape, but may have different sizes and/or shapes.

Again, in any one of the foregoing embodiments of the present invention, where the article to be transported is, for example, the printed circuit board having semiconductor elements mounted thereon and, hence, requiring destaticization, an electroconductive paint may be applied to the outer surface of the element 4, 20, 30, 50, 90 and 60 or an electroconductive powder such as carbon or metal particles or metal fibers may be mixed in such element.

## Claims

1. A pallet for the support of an electronic article (1) thereon, said electronic article having a plurality of projections (2) protruding outwardly therefrom, which pallet (10) comprises first and second surfaces opposite to each other, said first surface adapted to support the electronic article (1) thereon;
**characterized in that** said first surface is capable of being detented by the weight of the article at respective locations aligned with the projections (2) of the electronic article (1) when the latter is placed thereon, to thereby prevent the electronic article (1) from being displaced in position relative to the pallet (10).

2. The pallet as claimed in claim 1, further comprising
a base (3) having a loading surface adapted to support the electronic article (1) thereon; and
a flexible covering (4; 20; 30; 50; 60; 90) fitted to the loading surface, said flexible covering defining said first surface and being capable of being dented by the projections (2) of the electronic article (1) when the latter is placed thereon, to thereby prevent the electronic article (1) from being displaced in position relative to the pallet (10) during transportation of the electronic article (1).

3. The pallet as claimed in claim 2, wherein said flexible covering is a soft sheet (4).

4. The pallet as claimed in claim 3, wherein said soft sheet (4) is made of a material selected from the group consisting of rubber and plastics.

5. The pallet as claimed in claim 4, wherein said soft sheet (4) has a hardness not greater than 50 degrees.

6. The pallet as claimed in claim 4, wherein said soft sheet (4) has a hardness within the range of 35 to 50 degrees.

7. The pallet as claimed in claim 4, wherein said rubber is selected from the group consisting of silicone rubber, fluorine rubber, butyl rubber, urethane rubber and natural rubber.

8. The pallet as claimed in claim 4, wherein said plastics is selected from the group consisting of silicone, polyvinyl chloride, nylon and styrene.

9. The pallet as claimed in claim 2, wherein said flexible covering is a sponge sheet (20; 30).

10. The pallet as claimed in claim 9, wherein said sponge sheet (30) comprises a layer (31) of sponge material sandwiched between skin layers (32).

11. The pallet as claimed in claim 9, wherein said sponge sheet (20; 30) is made of a material selected from the group consisting of foamed silicone rubber and foamed urethane rubber.

12. The pallet as claimed in claim 10, wherein said sponge sheet (30) is made of a material selected from the group consisting of foamed silicone rubber, foamed styrene and foamed urethane rubber.

13. The pallet as claimed in claim 2, wherein said flexible covering (30) comprises a honeycomb structure (72) sandwiched between skin layers (32).

14. The pallet as claimed in claim 2, wherein said flexible covering comprises a generally flattened hollow member (50; 60; 90).

15. The pallet as claimed in claim 14, wherein said hollow member (50) has a plurality of hollows (51, 52) defined therein and partitioned by a partition wall (53).

16. The pallet as claimed in claim 14, wherein surface areas of the hollow member (50; 90) aligned with the respective hollows (51, 52) are outwardly convexed to provide associated thin-walled protrusions (12).

17. The pallet as claimed in claim 15, wherein said hollows (51, 52) are communicated with each other.

18. The pallet as claimed in claim 2, wherein said flexible covering comprises a textile sheet having a substantial thickness, said textile sheet being made of a textile material selected from the group consisting of a web of woven fabric, a web of non-woven fabric, a web of felt, a web of blanket, a sheet knitted with woolen yarn, and a quilted fabric having a cushioning material sandwiched between and sewn together with webs of fabric.

19. A transport apparatus which comprises:
a pallet (10) for the support of an electronic article (1) thereon according to at least any one of the preceding claims; and a conveyor (200) for transporting the electronic article (1) together with the pallet (10) carrying such electronic article (1) thereon.

20. The transport apparatus as claimed in claim 19, wherein said conveyor (200) is selected from the group consisting of a belt conveyor, a chain conveyor, a roller conveyor and a combination thereof.

21. A method of transporting an electronic article (1), which has a plurality of projections (2) protruding outwardly therefrom, by means of a transport means (200) and a pallet (10) having first and second surfaces opposite to each other, said first surface adapted to support the electronic article (1) thereon, said method comprising transporting the electronic article (1) while the first surface of the pallet (10) is detented by the weight of the article at respective locations aligned with the projections (2) of the electronic article (1) placed thereon to thereby prevent the electronic article (1) from being displaced in position relative to the pallet (10) during transportation of the electronic article (1).

22. The method as claimed in claim 21, wherein said pallet (10) comprises a base (3) having a loading surface adapted to support the electronic article (1) thereon, and a flexible covering (4; 20; 30; 50; 60; 90) fitted to the loading surface and defining said first surface, said method comprising transporting the electronic article (1) while the flexible covering is detented
by the projections (2) of the electronic article (1) when the latter is placed thereon to thereby prevent the electronic article (1) from being displaced in position relative to the pallet (10) during transportation of the electronic article (1).

23. The method as claimed in claim 21 or 22, wherein said transport means (200) is a conveyor selected from the group consisting of a belt conveyor, a chain conveyor, a roller conveyor and a combination thereof.

## Patentansprüche

1. Palette zum Tragen eines elektronischen Gegenstandes (1), der eine Vielzahl sich nach außen erstreckender Vorsprünge (2) aufweist, wobei die Palette (10) erste und zweite sich gegenüberliegende Oberflächen aufweist, wobei die erste Oberfläche dazu ausgebildet ist, den elektronischen Gegenstand (1) zu tragen;
**dadurch gekennzeichnet, dass** die erste Oberfläche eingedrückt werden kann durch das Gewicht des Gegenstandes an entsprechenden Positionen in Ausrichtung mit den Vorsprüngen (2) des elektronischen Gegenstandes (1), wenn dieser darauf platziert ist, um eine Verschiebung des elektronischen Gegenstands (1) in seiner Position relativ zu der Palette (10) zu verhindern.

2. Palette nach Anspruch 1, weiter umfassend eine Basis (3) mit einer Beladeoberfläche, die dazu ausgebildet ist, den elektronischen Gegenstand (1) zu tragen; und
eine flexible Abdeckung (4; 20; 30; 50; 60; 90), die an der Beladeoberfläche befestigt ist, wobei die flexible Abdeckung die erste Oberfläche bildet und eingedrückt werden kann durch die Vorsprünge (2) des elektronischen Gegenstandes (1), wenn dieser darauf platziert ist, um eine Verschiebung des elektronischen Gegenstands (1) in seiner Position relativ zur Palette (10) während des Transports des elektronischen Gegenstandes (1) zu verhindern.

3. Palette nach Anspruch 2, wobei die flexible Abdeckung eine weiche Auflage (4) ist.

4. Palette nach Anspruch 3, wobei die weiche Auflage (4) aus einem Material hergestellt ist, das ausgewählt ist aus der Gruppe bestehend aus Gummi und Kunststoffen.

5. Palette nach Anspruch 4, wobei der die weiche Auflage (4) eine Härte nicht größer als 50 Grad aufweist.

6. Palette nach Anspruch 4, wobei der die weiche Auflage (4) eine Härte in dem Bereich von 35 bis 50 Grad aufweist.

7. Palette nach Anspruch 4, wobei das Gummi ausgewählt ist aus der Gruppe bestehend aus Silikongummi, Fluorgummi, Butylgummi, Urethangummi und natürlichem Gummi.

8. Palette nach Anspruch 4, wobei die Kunststoffe ausgewählt sind aus der Gruppe bestehend aus Silikon, Polyvinylchlorid, Nylon und Styrol.

9. Palette nach Anspruch 2, wobei die flexible Abdeckung eine Schwammauflage (20; 30) ist.

10. Palette nach Anspruch 9, wobei die Schwammauflage (30) eine Schicht (31) aus Schwammmaterial beinhaltet, die sandwichartig zwischen Hautschichten (32) angeordnet ist.

11. Palette nach Anspruch 9, wobei die Schwammauflage (20; 30) aus einem Material hergestellt ist, das ausgewählt ist aus der Gruppe bestehend aus aufgeschäumtem Silikongummi und aufgeschäumtem Urethangummi.

12. Palette nach Anspruch 10, wobei die Schwammauflage (30) aus einem Material hergestellt ist, das ausgewählt ist aus den Gruppen bestehend aus aufgeschäumtem Silikongummi, aufgeschäumtem Styrol und aufgeschäumtem Urethangummi.

13. Palette nach Anspruch 2, wobei die flexible Abdeckung (30) eine Wabenstruktur (72) aufweist, die zwischen Hautschichten (32) sandwichartig angeordnet ist.

14. Palette nach Anspruch 2, wobei die flexible Abdeckung ein im Wesentlichen abgeflachtes hohles Teil (50; 60; 90) umfasst.

15. Palette nach Anspruch 14, wobei in dem hohlen Teil (50) eine Vielzahl von Hohlräumen (51, 52) ausgebildet und durch eine Trennungswand (53) unterteilt sind.

16. Palette nach Anspruch 14, wobei Oberflächenbereiche des hohlen Teils (50; 90) bei den entsprechenden Hohlräumen (51, 52) nach außen gewölbt sind, um zugeordnete dünnwandige Vorsprünge (12) bereitzustellen.

17. Palette nach Anspruch 15, wobei die Hohlräume (51, 52) miteinander verbunden sind.

18. Palette nach Anspruch 2, wobei die flexible Abdeckung eine Textilauflage umfasst mit einer substanziellen Dicke, und die Textilauflage hergestellt ist aus einem Textilmaterial ausgewählt aus der Gruppe bestehend aus einem Gewebe aus gewebtem Stoff, einem Gewebe aus ungewebtem Stoff, einem Gewebe aus Fell, einem Gewebe aus Deckenmaterial, einem aus Wollgarn gestrickten Tuch und einem gesteppten Stoff mit einem dämpfenden Material sandwichartig dazwischen angeordnet und mit Stoffgewebe zusammengenäht.

19. Transportvorrichtung umfassend eine Palette (10) zum Tragen eines elektronischen Gegenstandes (1) entsprechend zumindest einem der vorstehenden Ansprüche; und einer Beförderungsvorrichtung (200) zum Transportieren des elektronischen Gegenstandes (1) zusammen mit der einen solchen elektronischen Gegenstand (1) tragenden Palette (10).

20. Transportvorrichtung nach Anspruch 19, wobei die Beförderungsvorrichtung (200) ausgewählt ist aus der Gruppe bestehend aus einem Bandförderer, einem Kettenförderer, einem Rollenförderer und einer Kombination daraus.

21. Verfahren zum Transportieren eines elektronischen Gegenstandes (1) der eine Vielzahl von sich davon nach außen erstreckenden Vorsprüngen (2) aufweist, mittels eines Transportmittels (200) und einer Palette (10) mit ersten und zweiten sich gegenüberliegenden Oberflächen, wobei die erste Oberfläche dazu ausgebildet ist, den elektronischen Gegenstand (1) zu tragen, und das Verfahren umfasst Transportieren des elektronischen Gegenstandes (1) während die erste Oberfläche der Palette (10) eingedrückt wird durch das Gewicht des Gegenstandes an entsprechenden Positionen in Ausrichtung mit den Vorsprüngen (2) des elektronischen Gegenstandes (1), der darauf platziert wird, um dadurch zu verhindern, dass der elektronische Gegenstand (1) während des Transportes des elektronischen Gegenstandes (1) in seiner Position relativ zur Palette (10) verschoben wird.

22. Verfahren nach Anspruch 21, wobei die Palette (10) umfasst eine Basis (3) mit einer Beladeoberfläche ausgebildet zum Tragen des elektronischen Gegenstandes (1), und einer flexiblen Abdeckung (4; 20; 30; 50; 60; 90), die an die Beladeoberfläche angepasst wird und die erste Oberfläche bildet, wobei das Verfahren umfasst Transportieren des elektronischen Gegenstandes (1) während die flexible Abdeckung eingedrückt wird durch die Vorsprünge (2) des elektronischen Gegenstandes (1), wenn dieser darauf platziert wird, um dadurch zu verhindern, dass der elektronische Gegenstand (1) während des Transports des elektronischen Gegenstandes (1) in seiner Position relativ zur Palette (10) verschoben wird.

23. Verfahren nach Anspruch 21 oder 22, wobei das Transportmittel (200) ein Förderer ist ausgewählt aus der Gruppe bestehend aus einem Bandförderer, einem Kettenförderer, einem Rollenförderer und einer Kombination daraus.

## Revendications

1. Palette pour porter dessus un article électronique (1), ledit article électronique ayant une pluralité de saillies (2) dépassant de celui-ci vers l'extérieur, laquelle palette (10) comporte une première et une seconde surface opposées l'une à l'autre, ladite première surface adaptée pour soutenir dessus l'article électronique (1) ;
**caractérisée en ce que** ladite première surface est capable d'être entamée par le poids de l'article à des endroits respectifs en alignement avec les saillies (2) de l'article électronique (1) lorsque ce dernier est placé dessus pour empêcher par ce moyen l'article électronique (1) de bouger de position relativement à la palette (10).

2. Palette selon la revendication 1, comprenant en outre
une base (3) ayant une surface de chargement adaptée pour soutenir dessus l'article électronique (1) ; et un revêtement souple (4; 20; 30; 50; 60; 90) fixé à la surface de chargement, ledit revêtement souple définissant ladite première surface et étant capable d'être entamé par les saillies (2) de l'article électronique (1) lorsque ce dernier est placé dessus, pour empêcher par ce moyen l'article électronique (1) de bouger de position relativement à la palette (10) pendant le transport de l'article électronique (1).

3. Palette selon la revendication 2, dans laquelle ledit revêtement souple est une feuille molle (4).

4. Palette selon la revendication 3, dans laquelle ladite feuille molle (4) est faite à partir d'un matériau choisi dans le groupe incluant le caoutchouc et les matières plastiques.

5. Palette selon la revendication 4, dans laquelle ladite feuille molle (4) a une dureté non supérieure à 50 degrés.

6. Palette selon la revendication 4, dans laquelle ladite feuille molle (4) a une dureté située dans la gamme de 35 à 50 degrés.

7. Palette selon la revendication 4, dans laquelle ledit caoutchouc est sélectionné dans le groupe comprenant le caoutchouc à base de silicone, de fluor, de butyle, d'uréthane et de caoutchouc naturel.

8. Palette selon la revendication 4, dans laquelle ledit plastique est sélectionné dans le groupe comprenant le silicone, le chlorure de polyvinyle, le Nylon et le styrène.

9. Palette selon la revendication 2, dans laquelle ledit revêtement souple est une feuille spongieuse (20; 30).

10. Palette selon la revendication 9, dans laquelle ladite feuille spongieuse (30) comporte une couche (31) de matériau spongieux pris en sandwich entre deux peaux (32).

11. Palette selon la revendication 9, dans laquelle ladite feuille spongieuse (20; 30) est fait à partir d'un matériau sélectionné dans un groupe comprenant un caoutchouc à base de mousse de silicone et un caoutchouc à base de mousse d'uréthane.

12. Palette selon la revendication 10, dans laquelle ladite feuille spongieuse (30) est faite en un matériau sélectionné dans le groupe comprenant du caoutchouc en mousse de silicone, de la mousse de styrène et de la mousse d'uréthane.

13. Palette selon la revendication 2, dans laquelle ledit revêtement souple (30) comporte une structure en nids d'abeilles (72) prise en sandwich entre deux peaux (32).

14. Palette selon la revendication 2, dans laquelle ledit revêtement souple comporte un élément creux généralement aplati (50; 60; 90).

15. Palette selon la revendication 14, dans laquelle ledit élément creux (50) comprend une pluralité de creux (51, 52) qui y sont définis et cloisonnés par une cloison (53).

16. Palette selon la revendication 14, dans laquelle les aires superficielles de l'élément creux (50; 90) en alignement avec les creux respectifs (51, 52) sont convexes vers l'extérieur pour faire des saillies à fines parois associées (12).

17. Palette selon la revendication 15, dans laquelle lesdits creux (51, 52) sont en communication les uns avec les autres.

18. Palette selon la revendication 2, dans laquelle ledit revêtement souple comporte un lé textile ayant une épaisseur substantielle, ledit lé textile étant fait en un matériau textile sélectionné dans un groupe se composant d'une toile de tissu tissé, une toile de tissu non tissé, une toile de feutre, une toile de couverture, un lé tricoté à l'aide d'un fil de laine, et un tissu matelassé ayant une matière faisant coussin pris en sandwich entre et cousu avec les toiles de tissu.

19. Un appareil de transport qui comprend :
une palette (10) pour soutenir dessus un article électronique (1) selon au moins une quelconque des revendications précédentes ; et un transporteur (200) destiné à transporter l'article électronique (1) en même temps que la palette (10) transportant dessus cet article électronique (1).

20. L'appareil de transport selon la revendication 19, dans lequel ledit transporteur (200) est sélectionné dans le groupe comprenant un convoyeur à bande, un transporteur à chaîne, un transporteur à galets et une combinaison de ceux-ci.

21. Un procédé de transport d'un article électronique (1), qui a une pluralité de saillies (2) dépassant de celui-ci vers l'extérieur, au moyen d'un moyen de transport (200) et d'une palette (10) ayant une première et une seconde surfaces opposées l'une par rapport à l'autre, ladite première surface adaptée pour soutenir dessus l'article électronique (1), ledit procédé comprenant le transport de l'article électronique (1) tandis que le poids de l'article à des endroits respectifs en alignement avec la première surface de la palette (10) est entamé par les saillies (2) de l'article électronique (1) placé dessus pour empêcher par ce moyen l'article électronique (1) de changer de position relativement à la palette (10) pendant le transport de l'article électronique (1).

22. Le procédé selon la revendication 21, dans lequel ladite palette (10) comporte une base (3) ayant une surface de chargement adaptée pour soutenir dessus l'article électronique (1), et un revêtement souple (4; 20; 30; 50; 60; 90) fixé à la surface de chargement et définissant ladite première surface, ledit procédé comprenant le transport de l'article électronique (1) tandis que le revêtement souple est entamé par les saillies (2) de l'article électronique (1) lorsque ce dernier est placé dessus pour empêcher par ce moyen l'article électronique (1) de bouger de position relativement à la palette (10) pendant le transport de l'article électronique (1).

23. Procédé selon la revendication 21 ou 22, dans lequel ledit moyen de transport (200) est un convoyeur sélectionné dans le groupe comprenant un convoyeur à bande, un convoyeur à chaîne, un convoyeur à galets et une combinaison de ceux-ci.
